# EUROPÄISCHE PATENTSCHRIFT

(11) **EP 0 920 242 B1**
(45) Veröffentlichungstag und Bekanntmachung des Hinweises auf die Patenterteilung: **06.06.2007**
(21) Anmeldenummer: 98117960.9
(22) Anmeldetag: 22.09.1998
(51) Int. Cl.: H05K 1/02, H05K 1/11

(54) **Schaltungsanordnung zum Schutz eines elektrischen Bauteils vor einem elektrischen Potential**
Circuit arrangement to protect an electrical component against an electrical potential
Circuit pour protéger un composant électrique contre un potentiel électrique

(30) Priorität: 28.11.1997 DE 19752781
(43) Veröffentlichungstag der Anmeldung: 02.06.1999
(73) Patentinhaber: WABCO GmbH, 30453 Hannover (DE)
(72) Erfinder: Gröger, Jens, 30449 Hannover (DE)
(74) Vertreter: Schrödter, Manfred

(56) Entgegenhaltungen:
- EP-A- 0 286 739
- GB-A- 2 272 108
- PATENT ABSTRACTS OF JAPAN vol. 016, no. 554 (E-1293), 25. November 1992 & JP 04 209557 A (SUMITOMO ELECTRIC IND LTD), 30. Juli 1992
- PATENT ABSTRACTS OF JAPAN vol. 018, no. 518 (E-1612), 29. September 1994 & JP 06 181400 A (FANUC LTD), 28. Juni 1994
- PATENT ABSTRACTS OF JAPAN vol. 016, no. 513 (E-1283), 22. Oktober 1992 & JP 04 192389 A (MERUKO:KK), 10. Juli 1992

## Beschreibung

Die Erfindung betrifft eine Schaltungsanordnung zum Schutz eines elektrischen Bauteils vor unerwünschten Werten eines elektrischen Potentials gemäß dem Oberbegriff des Patentanspruchs 1.

Derartige Schaltungsanordnungen kommen z. B. dann zum Einsatz, wenn ein elektrisches Gerät an einer Einrichtung zur Spannungsversorgung betrieben wird, bei der unzulässige Spannungswerte, wie z. B. eine zu hohe Ausgangsspannung, auftreten können. Hierfür sei beispielhaft die typische Spannungsversorgungsanlage in einem Kraftfahrzeug genannt, die einen Drehstromgenerator mit einem Regler sowie eine Batterie aufweist. In derartigen Anlagen werden bestimmte, von dem Drehstromgenerator erzeugte Spannungsspitzen nicht in allen Fällen zuverlässig von dem Regler oder der Batterie unterdrückt, so daß derartige Spannungsspitzen zu den unter Umständen empfindlichen elektrischen Geräten, die mit der Spannungsversorgungsanlage versorgt werden, gelangen können. In solchen Fällen können Beschädigungen an den elektrischen Geräten auftreten, sofern keine Schutzmaßnahmen vorgesehen sind.

Eine bekannte Schutzmaßnahme für ein elektrisches Gerät besteht darin, in dem elektrischen Gerät eine Schaltungsanordnung zum Schutz empfindlicher Bauteile vorzusehen, die dem zu schützenden Bauteil parallel geschaltet ist und ansonsten zwischen der Quelle des elektrischen Potentials, also in der Regel der Spannungsversorgungsanlage, und dem zu schützenden Bauteil angeordnet ist. Als Schutzelement werden häufig sogenannte Suppressor-Dioden eingesetzt, die die besondere Eigenschaft haben, bei einer unzulässig hohen Spannung zwischen ihren beiden Anschlüssen eine Verbindung zwischen den Anschlüssen herzustellen, wodurch innerhalb des elektrischen Gerätes diese Spannung kurzgeschlossen wird und damit nicht das zu schützende Bauteil erreicht. Hierbei ist in oder vor dem elektrischen Gerät zur Vermeidung von Folgeschäden durch den Kurzschluß noch eine Sicherung angeordnet.

Bei den bekannten Schutzelementen tritt das Problem auf, daß die Schutzwirkung bei Auftreten der unzulässigen Spannung mit einer gleichzeitigen starken Erwärmung des Schutzelements einhergeht. Da derartige Schutzelemente in der Regel auf elektrischen Leiterplatten angeordnet sind und mit einer solchen Leiterplatte zumeist durch Löten elektrisch verbunden sind, kann es passieren, daß durch die Erwärmung des Schutzelements beim Schutzvorgang das ebenfalls zur mechanischen Befestigung des Schutzelements verwendete Lötmittel ebenfalls erwärmt wird. Infolgedessen wird das Lötmittel zunächst flüssig, wodurch es unter Umständen abfließt. Bei stärkerer Erwärmung ist es auch möglich, daß das Lötmittel verdampft. In beiden Fällen ist eine mechanische Fixierung und damit ein sicherer elektrischer Anschluß des Schutzelements nicht mehr gewährleistet.

Auch ohne die zuvor genannten Effekte, nämlich Abflie-ßen oder Verdampfen des Lötmittels, ist bereits bei einer Verflüssigung des Lötmittels ein sicherer Anschluß des Schutzelements nicht mehr gewährleistet, wenn mechanische Erschütterungen auf das Schutzelement bzw. das elektrische Gerät einwirken. In einem solchen Fall besteht die Gefahr, daß das Schutzelement von der Leiterplatte fällt, bevor die Schutzwirkung eingetreten ist bzw. die Sicherung zerstört worden ist, sofern das Schutzelement ausschließlich durch das Lötmittel mechanisch fixiert wird.

Die zuvor genannte Gefahr kann verringert werden, wenn das Schutzelement zusätzlich zur Verlötung noch auf eine andere Weise mechanisch fixiert wird, z. B. durch Klebstoff oder durch Verbiegen von elektrischen Anschlußdrähten. Die zuletzt genannte Maßnahme wäre allerdings bei sogenannten oberflächenmontierbaren Bauteilen (SMD = Surface Mounted Devices) nicht anwendbar. Ein anderer Nachteil derartiger Befestigungsmethoden ist, daß ein zusätzlicher Aufwand und dadurch zusätzliche Kosten bei der Herstellung des elektrischen Gerätes entstehen.

Aus der DE 196 47 035 A1 ist eine gattungsgemäße Schaltungsanordnung bekannt, bei der mittels eines speziell hierfür herzustellenden, relativ aufwendig geformten Federelements ein definiertes Herauslösen und Entfernen des dortigen Schutzelements im Fall/e eines unerwünscht hohen elektrischen Potentials vorgesehen ist. Die Verwendung der dort angegebenen Feder erhöht den Platzaufwand und die Kosten für die dortige Schaltungsanordnung. Außerdem muß die Feder aufgrund ihrer speziellen Formgebung eigens für diesen Zweck hergestellt werden. Des weiteren ist ein zusätzlicher Montageschritt zur Montage der Feder erforderlich, der nur schwer automatisierbar ist.

Der Erfindung liegt daher die Aufgabe zugrunde, eine Schaltungsanordnung zum Schutz eines elektrischen Bauteils vor unerwünschten Werten eines elektrischen Potentials anzugeben, bei der auf einfache Weise ein zuverlässiger Schutz des elektrischen Bauteils vor den unerwünschten Werten des elektrischen Potentials mit herkömmlichen Schutzelementen ermöglicht wird.

Diese Aufgabe wird durch die im Patentanspruch 1 angegebene Erfindung gelöst. Weiterbildungen und vorteilhafte Ausgestaltungen der Erfindung sind in den Unteransprüchen angegeben.

Ein Vorteil der Erfindung besteht in ihrer Einsetzbarkeit in beliebigen elektrischen Geräten, ohne daß ein zusätzlicher Aufwand bei der Herstellung des elektrischen Gerätes erforderlich ist. Es ist lediglich bei der Herstellung desjenigen Teils, auf dem das Schutzelement angeordnet werden soll, an derjenigen Stelle, an der das Schutzelement ohnehin mit einer das elektrische Potential zu dem elektrischen Bauteil hinführenden Leitung verbunden wird, eine Unterbrechungsstelle vorzusehen. Insbesondere bei Verwendung einer elektrischen Leiterplatte als Träger für das Schutzelement und gegebenenfalls das zu schützende elektrische Bauteil ist hierfür kein zusätzlicher Aufwand bei der Herstellung der Leiterplatte erforderlich. Die Verwendung weiterer Hilfsmittel zur mechanischen Fixierung des Schutzelements, wie z. B. ein Halteblech oder Klebstoff, der zudem sehr temperaturfest sein müßte, erübrigt sich.

Die Funktionsweise der Erfindung besteht darin, daß beim Eintreten der Schutzwirkung ein Abfließen oder Verdampfen des Lötmittels oder ein Herausfallen des Schutzelements ein Auftrennen der erfindungsgemäßen Unterbrechungsstelle, die vor Eintreten der Schutzwirkung durch einen Anschluß des Schutzelements überbrückt ist, bewirkt, so daß auch ohne die Schutzwirkung des Schutzelements das zu schützende Bauteil sicher vor dem unzulässigen Wert des elektrischen Potentials geschützt wird, weil das zu schützende Bauteil dann nicht mehr mit diesem Potential verbunden ist. Die Erfindung deckt somit alle beschriebenen Fälle, die infolge der Schutzwirkung auftreten können, ab.

In einer vorteilhaften Weiterbildung der Erfindung ist das Schutzelement als ein oberflächenmontierbares Bauteil (SMD) zur Befestigung auf einer elektrischen Leiterplatte ausgebildet. Dies hat den Vorteil, daß als Schutzelement sehr kostengünstige Bauteile eingesetzt werden können.

Gemäß der Erfindung ist an derjenigen Stelle der Leitung, an der der Anschluß des Schutzelements die durch die Unterbrechungsstelle voneinander getrennten Teile der Leitung verbindet, ein spezieller Anschlußplatz vorgesehen, der in seiner Form nach den Gegebenheiten des Schutzelements derart ausgebildet ist, daß das Schutzelement eine sichere mechanische und elektrische Verbindung zu den Teilen der Leitung hat, indem der Anschlußplatz als Lötpad ausgebildet ist, was insbesondere bei Verwendung eines oberflächenmontierbaren Bauteils als Schutzelement vorteilhaft ist. Hierbei handelt es sich um ein im Vergleich zu der Breite der übrigen Leitungen relativ breites Leiterbahnstück, das in seiner Form dem darauf zu montierenden Bauteil angepaßt ist. Lötpads sind zumeist rechteckförmig ausgebildet.

Da die hier in Betracht kommenden Schutzelemente, wie z. B. eine Diode, ein Varistor oder ein Thyristor, regelmäßig wenigstens einen weiteren Anschluß aufweisen, besteht die Notwendigkeit, daß beim Eintreten der zuvor beschriebenen Funktionsweise der Erfindung ein Auftrennen der Unterbrechungsstelle auch an demjenigen Anschluß erfolgt, an dem die Unterbrechungsstelle vorgesehen ist. Dies ist in der Regel beim Einsatz herkömmlicher Schutzelemente allein dadurch sichergestellt, daß diese ein unsymmetrisches Gehäuse aufweisen, was zu einer ungleichmäßigen Temperaturverteilung in dem Gehäuse und hierdurch auch an den Anschlüssen des Schutzelements führt. Es wird daher vorzugsweise derjenige Anschluß des Schutzelements, bei dem aufgrund der zu erwartenden Temperaturverteilung beim Eintreten der Schutzwirkung die höchste Temperatur auftritt, zur Überbrückung der Unterbrechungsstelle verwendet.

Gemäß der Erfindung ist für den wenigstens einen weiteren Anschluß des Schutzelements ein weiterer Anschlußplatz vorgesehen, der einen größeren Flächeninhalt aufweist als die Teile des geteilten Anschlußplatzes gemeinsam. Hierdurch kann die zuvor beschriebene, erwünschte Temperaturverteilung auch bei Schutzelementen, die verhältnismäßig symmetrische Gehäuse aufweisen, in der gewünschten Weise beeinflußt werden, d. h. es wird die Wärmeableitung an dem weiteren, keine Unterbrechungsstelle aufweisenden Anschlußplatz gezielt verbessert.

In einer anderen vorteilhaften Weiterbildung weist auch der weitere Anschlußplatz bzw. die weiteren Anschlußplätze jeweils eine Unterbrechungsstelle auf. Dies hat den Vorteil, daß thermodynamische Effekte bei der Konstruktion des elektrischen Gerätes unberücksichtigt bleiben können.

Gemäß einer vorteilhaften Weiterbildung der Erfindung wird ein Schutzelement verwendet, das beim Eintreten der Schutzwirkung seine äußere geometrische Form verändert, was zur Folge hat, daß der die Unterbrechungsstelle überbrückende Anschluß des Schutzelements sich beim Eintreten der Schutzwirkung mechanisch von der Unterbrechungsstelle entfernt und somit die Teile der Leitung nicht mehr miteinander verbunden sind. Vorzugsweise nimmt dabei das Schutzelement eine zu der Leiterplatte, auf der es angeordnet ist, konvexe Form an, so daß sich der die Unterbrechungsstelle zuvor überbrückende Anschluß dann von der Leiterplatte abhebt.

Die Erfindung wird im folgenden anhand eines Ausführungsbeispiels unter Zuhilfenahme von Zeichnungen näher erläutert.

Es zeigen
- Fig. 1: ein elektrisches Schaltschema der erfindungsgemäßen Schaltungsanordnung und
- Fig. 2: eine Draufsicht auf das Schutzelement und den die Erfindung betreffenden Teil einer elektrischen Leiterplatte und
- Fig. 3: die Darstellung gemäß Fig. 2 ohne das Schutzelement und
- Fig. 4: eine Seitenansicht der Darstellung gemäß Fig. 2 vor Eintreten der Schutzwirkung und
- Fig. 5: die Darstellung gemäß Fig. 4 nach Eintreten der Schutzwirkung.

In den Figuren werden gleiche Bezugszeichen für einander entsprechende Teile verwendet.

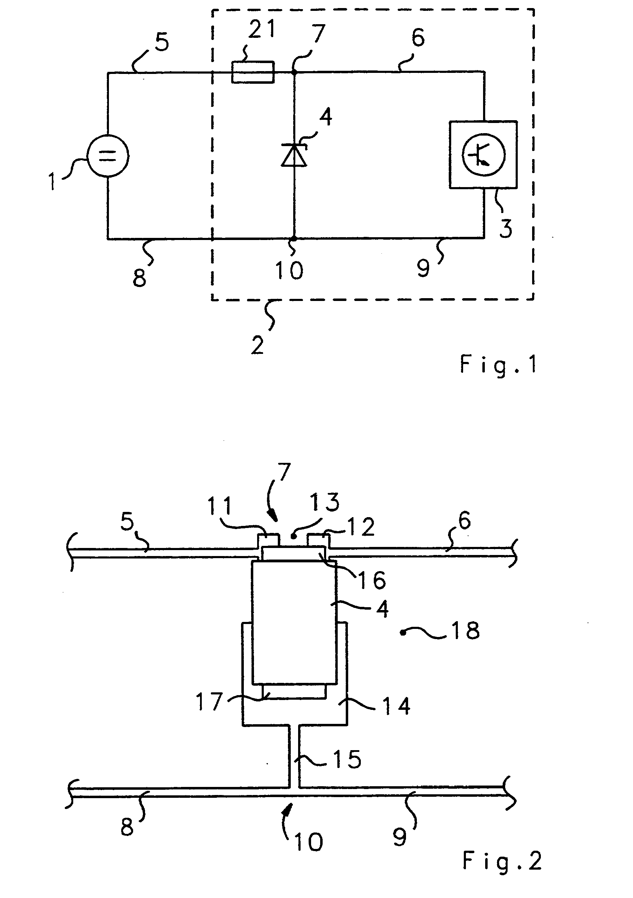

In der Fig. 1 ist die prinzipielle Art einer Schaltungsanordnung zum Schutz elektrischer Bauteile vor unzulässigen elektrischen Potentialen dargestellt. Die Darstellung gemäß Fig. 1 trifft sowohl auf bekannte Schaltungsanordnungen als auch auf die erfindungsgemäße Schaltungsanordnung zu.

Eine symbolisch dargestellte Einrichtung zur Spannungsversorgung (1) gibt eine elektrische Potentialdifferenz über elektrische Leitungen (5, 8) an ein elektrisches Gerät (2) ab. Bei der Einrichtung (1) handelt es sich beispielsweise um eine Spannungsversorgungsanlage in einem Kraftfahrzeug, die einen Drehstromgenerator, einen Transistorregler und eine Batterie aufweist, oder auch um ein unzureichend stabilisiertes Netzteil.

In dem elektrischen Gerät (2) ist ein elektrisches Bauteil (3) angeordnet, das für den Betrieb an einer Betriebsspannung vorgesehen ist, die in einem bestimmten, zulässigen Bereich liegen muß. Im Falle einer außerhalb dieses Bereiches liegenden Betriebsspannung kann das elektrische Bauteil (3) beschädigt werden. Als elektrisches Bauteil (3) kann, je nach Anwendungsfall, ein einziges elektrisches oder elektronisches Bauelement, wie z. B. eine Leuchtdiode, oder auch eine eine Vielzahl von elektrischen oder elektronischen Bauelementen aufweisende Schaltungsanordnung, z. B. mit einem Mikroprozessor und einem Speicherbaustein, verwendet werden. Das elektrische Bauteil (3) wird über elektrische Leitungen (6, 9) mit der dem elektrischen Gerät (2) zugeführten Potentialdifferenz als Betriebsspannung versorgt.

Dem elektrischen Bauteil (3) ist ein Schutzelement (4) parallel geschaltet. Das Schutzelement (4) ist in dem Ausführungsbeispiel gemäß Fig. 1 als Suppressor-Diode ausgebildet und hat die Eigenschaft, beim Anlegen einer einen bestimmten Wert überschreitenden elektrischen Spannung eine Verbindung zwischen seinen beiden Anschlüssen herzustellen, was auch als Durchlegieren bezeichnet wird. Wegen dieser speziellen Art der Schutzwirkung erfordert die Diode (4) eine parallele Anordnung zu dem elektrischen Bauteil (3). Daher ist die Diode (4) an einem Anschlußpunkt (7) mit den Leitungen (5, 6) und an einem Anschlußpunkt (10) mit den Leitungen (8, 9) verbunden.

Die Leitung (5) weist außerdem eine Sicherung (21) auf. Die Sicherung kann, wie in der Fig. 1 dargestellt, innerhalb des elektrischen Gerätes (2) oder auch außerhalb dessen angeordnet sein.

Falls nun aufgrund einer Fehlfunktion der Einrichtung zur Spannungsversorgung (1) unzulässige elektrische Potentiale bzw. eine unzulässig hohe oder tiefe Potentialdifferenz über die elektrischen Leitungen (5, 8) zu dem elektrischen Gerät (2) gelangt, so würde die Diode (4) durchlegieren und somit einen Kurzschluß zwischen den Anschlußpunkten (7, 10) verursachen. Hierdurch kann die unzulässige Potentialdifferenz nicht über die Leitungen (6, 9) zu dem elektrischen Bauteil (3) gelangen. Darüber hinaus spricht kurz darauf die Sicherung (21) an und unterbricht einen weiteren, durch den Kurzschluß verursachten Stromfluß. Hierdurch wird das elektrische Bauteil (3) vor einer Beschädigung geschützt.

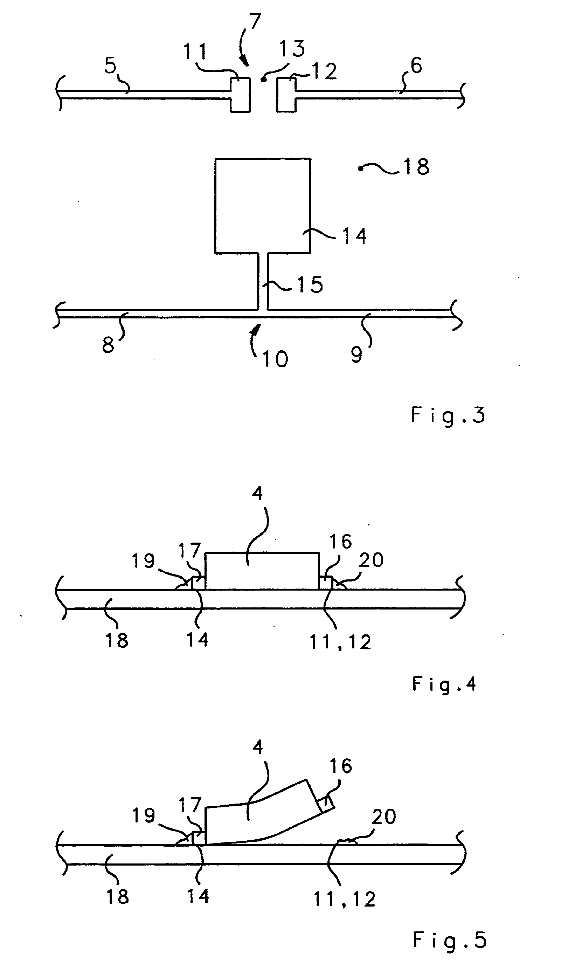

In den Fig. 2 und 3 ist die in der Fig. 1 mit elektrischen Schaltsymbolen dargestellte Schaltungsanordnung ausschnittsweise dargestellt. Es fehlen die Teile (1, 3, 21). In der Fig. 3 ist außerdem die Diode (4) nicht dargestellt.

Die Leitungen (5, 6, 8, 9) sind in den Fig. 2 und 3 ebenfalls ausschnittsweise als elektrische Leiterbahnen dargestellt, die zum besseren Verständnis mit gleichen Bezugszeichen versehen sind.

Die Fig. 2 zeigt eine Draufsicht auf eine elektrische Leiterplatte (18), auf der elektrische Leiterbahnen (5, 6, 8, 9, 15), ein erstes Lötpad (11, 12) und ein zweites Lötpad (14) angeordnet sind. Die Lötpads (11, 12, 14) werden zum Teil von der darauf angeordneten Diode (4) überdeckt. Die Diode (4) weist Anschlüsse (16, 17) auf, die mittels eines Lötmittels, vorzugsweise durch Lötzinn, elektrisch und mechanisch mit den Lötpads (11, 12, 14) verbunden ist. Im übrigen ist das Lötpad (11, 12) mit den Leiterbahnen (5, 6) verbunden. Das Lötpad (14) ist über eine Leiterbahn (15) mit den Leiterbahnen (8, 9) verbunden.

Das Lötpad (11, 12) weist eine Unterbrechungsstelle (13) auf, durch die das Lötpad in zwei einzelne, elektrisch voneinander getrennte Teile (11 bzw. 12) unterteilt wird. Hierbei ist der Teil (11) mit dem zu der Einrichtung zur Spannungsversorgung (1) führenden Leiterbahn (5) verbunden. Der Teil (12) ist mit der zu dem elektrischen Bauteil (3) führenden Leiterbahn verbunden. Vor Eintritt der Schutzwirkung, d. h. vor dem Durchlegieren der Diode (4), überbrückt der Anschluß (16) der Diode (4) die Unterbrechungsstelle (13), so daß die Teile (11, 12) des Lötpads mittels des Lötmittels elektrisch verbunden sind.

Wenn die Schutzwirkung eintritt, d. h. wenn die Diode (4) aufgrund einer zu hohen elektrischen Spannung durchlegiert ist, verflüssigt sich das Lötmittel infolge einer Erwärmung der Diode (4). Je nach Stärke der Erwärmung kann es auch passieren, daß das Lötmittel verdampft. In diesem Fall ist die zuvor erwünschte Überbrückung der Unterbrechungsstelle (13) durch den Anschluß (16) nicht mehr sicher gewährleistet, was durchaus erwünscht ist, weil auch hierdurch das elektrische Bauteil (3) vor den unzulässigen Spannungswerten geschützt wird. Je nach Stärke und Dauer der Erwärmung kann es bei mechanischen Erschütterungen des elektrischen Gerätes (2) auch passieren, daß sich die Diode (4) von der Leiterplatte (18) löst, wie in der Fig. 3 dargestellt.

In der Fig. 3 ist die zuvor mit der Fig. 2 beschriebene Anordnung ohne die Diode (4) dargestellt, d. h. entweder vor dem Auflöten der Diode (4) bei der Herstellung des elektrischen Gerätes (2) oder nach dem Auslöten infolge der Erwärmung.

Die Unterbrechungsstelle (13) stellt eine Trennlinie zwischen den Teilen (11, 12) des geteilten Lötpads dar. Diese Teilungslinie ist vorzugsweise senkrecht oder nahezu senkrecht zu den unmittelbar benachbarten Leiterbahnen (5, 6) angeordnet. Hierdurch können handelsübliche Suppressor-Dioden in SMD-Bauweise verwendet werden, wie in der Fig. 2 und 4 dargestellt.

Das Lötpad (14) weist einen größeren Flächeninhalt auf als die Teile (11, 12) des geteilten Lötpads. Hierdurch ist auch bei Einsatz von symmetrisch aufgebauten Schutzelementen eine entsprechende unsymmetrische Temperaturverteilung sichergestellt, derart, daß die Wärmeableitung an dem nicht geteilten Lötpad (14) im Vergleich zu dem geteilten Lötpad (11, 12) verbessert ist. Aus diesem Grunde führt eine Erwärmung des Schutzelements (4) an dem geteilten Lötpad (11, 12) zu einem schnelleren Temperaturanstieg als an dem ungeteilten Lötpad (14), so daß sich das Lötmittel dort zuerst verflüssigt.

In den Fig. 4 und 5 ist der in der Fig. 2 dargestellte Ausschnitt des elektrischen Gerätes (2) in einer Seitenansicht dargestellt.

In der Fig. (4) ist die Schutzwirkung noch nicht eingetreten. Die Diode (4) ist über ihre elektrischen Anschlüsse (16, 17) und das Lötmittel (19, 20) mit den zuvor beschriebenen, auf der Leiterplatte (18) angeordneten Lötpads (11, 12, 14) elektrisch und mechanisch verbunden. In der hier dargestellten Ausführungsart wird eine Diode (4) eingesetzt, die sich beim Eintreten der Schutzwirkung, d. h. bei Erwärmung, mechanisch verformt.

In der Fig. 5 ist eine derart mechanisch verformte Diode (4) dargestellt. Die Diode (4) wölbt sich bei Eintreten der Schutzwirkung von der Leiterplatte (18) weg, d. h. derjenige Anschluß, an dem sich das Lötmittel zuerst verflüssigt, entfernt sich von der Leiterplatte (18). In diesem Fall handelt es sich um den Anschluß (16). Ein derartiges Verhalten der Diode (4) kann durch einen mehrschichtigen Aufbau der Diode (4) gezielt in der gewünschten Weise vorgesehen werden, indem die Diode (4) aus wenigstens zwei Schichten von Materialien mit unterschiedlichem thermischen Ausdehnungskoeffizienten besteht.

## Patentansprüche

1. Schaltungsanordnung zum Schutz eines elektrischen Bauteiles (3) vor unerwünschten Werten der von einer Einrichtung zur Spannungsversorgung (1) abgegebenen elektrischen Potentialdifferenz mit folgenden Merkmalen:
a) das elektrische Bauteil (3) ist über eine Leitung (5, 6) sowie über eine weitere Leitung (8) mit der von der Einrichtung (1) abgegebenen Potentialdifferenz verbunden,
b) es ist ein Schutzelement (4) vorgesehen, das mittels eines Lötmittels mit einem Anschluss (16) mit der Leitung (5, 6) verbunden ist und mit einem weiteren Anschluss (17) mit der weiteren Leitung (8) verbunden ist,
c) das Schutzelement (4) bewirkt bei unzulässigen Werten der Potentialdifferenz eine Verbindung zwischen den Anschlüssen (16, 17),
d) die Leitung (5, 6) weist eine Unterbrechungsstelle (13) auf,
e) der Anschluss (16) des Schutzelements verbindet die durch die Unterbrechungsstelle (13) voneinander getrennten Teile der Leitung (5, 6)
**dadurch gekennzeichnet, dass**
f) die Leitung (5) eine Sicherung (21) aufweist, die zwischen der Einrichtung zur Spannungsversorgung (1) und dem Schutzelement (4) angeordnet ist,
g) sofern bei Vorhandensein der unzulässigen Werte der Potentialdifferenz die Sicherung (21) nicht anspricht, sich das Schutzelement (4) erwärmt,
h) wobei die Erwärmung des Schutzelements (4) zu einer Verflüssigung des Lötmittels führt, in dessen Folge das Schutzelement sich von der Leiterplatte löst und dabei die Unterbrechungsstelle (13) aufgetrennt wird,
i) zum Anschluß des Schutzelements (4) an die Leitung (5, 6) ein als Lötpad ausgebildeter Anschlußplatz (11, 12), insbesondere für ein oberflächenmontierbares Bauteil, vorgesehen ist,
k) der Anschlußplatz (11, 12) die Unterbrechungsstelle (13) derart enthält, daß er in wenigstens zwei voneinander elektrisch getrennte Teile geteilt ist, wobei jeweils ein Teil (5 bzw. 6) der elektrischen Leitung mit einem Teil (11 bzw. 12) des Anschlußplatzes elektrisch verbunden ist,
l) wobei das Schutzelement (4) mit dem weiteren Anschluß (17) an einem weiteren Anschlußplatz (14) befestigt ist, der einen größeren Flächeninhalt aufweist als die Teile des geteilten Anschlußplatzes (11,12) gemeinsam, um bei einer Erwärmung des Schutzelements eine unsymmetrische Temperaturverteilung sicherzustellen.

2. Schaltungsanordnung nach Patentanspruch 1, **gekennzeichnet durch** die Verwendung eines Schutzelements (4), das beim Ansprechen seiner Schutzfunktion, insbesondere bei Erwärmung, seine geometrische Form ändert.

3. Schaltungsanordnung nach einem der vorhergehenden Patentansprüche, **dadurch gekennzeichnet, daß** das Schutzelement (4) als ein auf einer elektrischen Leiterplatte (18) oberflächenmontierbares Bauteil ausgebildet ist.

4. Schaltungsanordnung nach Patentanspruch 1 bis 3, **dadurch gekennzeichnet, daß** der geteilte Anschlußplatz (11, 12) eine Teilungslinie aufweist, die senkrecht oder nahezu senkrecht zu den unmittelbar benachbarten Teilen der Leitung (5, 6) ist.

5. Schaltungsanordnung nach einem der Patentansprüche 1 bis 4, **dadurch gekennzeichnet, daß** die Teile des geteilten Anschlußplatzes (11, 12) einen Abstand von wenigstens 0,7 mm voneinander aufweisen.

6. Schaltungsanordnung nach einem der vorhergehenden Patentansprüche, **dadurch gekennzeichnet, daß** das Schutzelement (4) als Diode oder als Varistor oder als Thyristor ausgebildet ist.

7. Schaltungsanordnung nach einem der vorhergehenden Patentansprüche, **dadurch gekennzeichnet, daß** das Schutzelement (4) dem zu schützenden elektrischen Bauteil (3) parallel geschaltet ist.

8. Schaltungsanordnung nach einem der vorhergehenden Patentansprüche, **dadurch gekennzeichnet, daß** der die Teile der elektrischen Leitung (5, 6) verbindende Anschluß (16) des Schutzelements (4) als wenigstens zwei voneinander getrennt montierbare, elektrisch miteinander verbundene Anschlußbeine ausgebildet ist.

9. Schaltungsanordnung nach einem der Patentansprüche 1 bis 8, **dadurch gekennzeichnet, daß** der weitere Anschlußplatz (14) wenigstens zwei voneinander elektrisch getrennte Teile aufweist.

10. Schaltungsanordnung nach einem der vorhergehenden Patentansprüche, **dadurch gekennzeichnet, daß** das Schutzelement (4) aus wenigstens zwei Schichten von Materialien mit unterschiedlichem thermischen Ausdehnungskoeffizienten besteht.

11. Schaltungsanordnung nach Patentanspruch 1, **dadurch gekennzeichnet, daß** als Lötmittel Lötzinn verwendet wird.

## Claims

1. Circuitry arrangement for protecting an electrical component (3) from undesirable values of electrical potential difference delivered by a voltage supply device (1), having the following features:
a) the electrical component (3) is connected by way of a line (5, 6) and also by way of a further line (8) to the potential difference delivered by the device (1),
b) a protective element (4) is provided which, by means of a solder, is connected by a terminal (16) to the line (5, 6) and connected by a further terminal (17) to the further line (8),
c) in the event of impermissible values of the potential difference the protective element (4) establishes a connection between the terminals (16, 17),
d) the line (5, 6) has an interruption location (13),
e) the terminal (16) of the protective element connects those parts of the line (5, 6) which are separated from one another by the interruption location (13),
**characterised in that**
f) the line (5) has a fuse (21), which is arranged between the voltage supply device (1) and the protective element (4),
g) if, when impermissible values of the potential difference are present, the fuse (21) does not operate, the protective element (4) heats up,
h) the heating of the protective element (4) resulting in liquefying of the solder, as a consequence of which the protective element comes away from the printed circuit board and in the process the interruption location (13) is separated,
i) for connection of the protective element (4) to the line (5, 6) there is provided a connection site (11, 12) in the form of a solder pad, especially for a surface-mountable device,
k) the connection site (11,12) includes the interruption location (13) so that the site is divided into at least two parts electrically isolated from one another, each part (5 and 6) of the electrical line being electrically connected to a part (11 and 12, respectively) of the connection site,
l) the protective element (4) being attached by the further terminal (17) to a further connection site (14), which has a surface area larger than the parts of the divided connection site (11, 12) together, in order to ensure asymmetrical temperature distribution in the event of heating of the protective element.

2. Circuitry arrangement according to patent claim 1, **characterised by** the use of a protective element (4) which, when its protective function comes into operation, especially on heating, changes its geometric shape.

3. Circuitry arrangement according to one of the preceding patent claims, **characterised in that** the protective element (4) is in the form of a device surface-mountable on an electric printed circuit board (18).

4. Circuitry arrangement according to patent claim 1 to 3, **characterised in that** the divided connection site (11, 12) has a line of division which is perpendicular or almost perpendicular to the immediately adjacent parts of the line (5, 6).

5. Circuitry arrangement according to one of patent claims 1 to 4, **characterised in that** the parts of the divided connection site (11, 12) have a spacing from one another of at least 0.7 mm.

6. Circuitry arrangement according to one of the preceding patent claims, **characterised in that** the protective element (4) is in the form of a diode or varistor or thyristor.

7. Circuitry arrangement according to one of the preceding patent claims, **characterised in that** the protective element (4) is connected in parallel with the electrical component (3) to be protected.

8. Circuitry arrangement according to one of the preceding patent claims, **characterised in that that** terminal (16) of the protective element (4) which connects the parts of the electrical line (5, 6) is in the form of at least two terminal legs electrically connected to one another and arranged to be mounted separately from one another.

9. Circuitry arrangement according to one of patent claims 1 to 8, **characterised in that** the further connection site (14) has at least two parts electrically isolated from one another.

10. Circuitry arrangement according to one of the preceding patent claims, **characterised in that** the protective element (4) is made of at least two layers of materials having different coefficients of thermal expansion.

11. Circuitry arrangement according to patent claim 1, **characterised in that** tin-based solder is used as the solder.

## Revendications

1. Circuit pour protéger un composant électrique (3) contre des valeurs non désirées de la différence de potentiel électrique délivrée par un dispositif d'alimentation en tension (1) comportant les caractéristiques suivantes:
a) le composant électrique (3) est relié à la différence de potentiel délivrée par le dispositif (1) par l'intermédiaire d'une ligne (5, 6) ainsi que par l'intermédiaire d'une autre ligne (8),
b) un élément de protection (4) est prévu, qui est relié à la ligne (5, 6) par un raccord (16) au moyen d'une brasure et est relié à l'autre ligne (8) par un autre raccord (17),
c) l'élément de protection (4) établit une liaison entre les raccords (16, 17) dans le cas de valeurs non fiables de la différence de potentiel,
d) la ligne (5, 6) présente un point d'interruption (13),
e) le raccord (16) de l'élément de protection relie les parties de la ligne (5, 6) séparées les unes des autres par le point d'interruption (13),
**caractérisé en ce que**
f) la ligne (5) présente un dispositif de sécurité (21), qui est disposé entre le dispositif d'alimentation en tension (1) et l'élément de protection (4),
g) si le dispositif de sécurité (21) ne se déclenche pas dans le cas de l'existence de valeurs non fiables de la différence de potentiel, l'élément de protection (4) chauffe,
h) l'échauffement de l'élément de protection (4) conduit à une fluidification de la brasure, ce qui a pour conséquence que l'élément de protection se détache du circuit imprimé et en outre le point d'interruption (13) est séparé,
i) en vue du raccord de l'élément de protection (4) à la ligne (5, 6), une pastille (11, 12) sous la forme d'un point de soudure est prévue, en particulier pour un composant pouvant être monté en surface,
k) la pastille (11, 12) comporte le point d'interruption (13) de sorte qu'elle est séparée au moins en deux parties électriquement séparées l'une de l'autre, moyennant quoi une partie respective (5 ou 6) de la ligne électrique est reliée électriquement à une partie (11 ou 12) de la pastille,
l) l'élément de protection (4) est fixé par un autre raccord (17) à une autre pastille (14), qui présente une superficie plus grande que les parties de pastille séparé (11, 12) ensemble, pour assurer une répartition de température non symétrique dans le cas de l'échauffement de l'élément de protection.

2. Circuit selon la revendication 1, **caractérisé par** l'utilisation d'un élément de protection (4), qui, dans le cas du déclenchement de sa fonction de protection, en particulier dans le cas d'un échauffement, modifie sa forme géométrique.

3. Circuit selon l'une des revendications précédentes, **caractérisé en ce que** l'élément de protection (4) est réalisé sous la forme d'un composant pouvant être monté en surface sur un circuit imprimé électrique (18).

4. Circuit selon la revendication 1 à 3, **caractérisé en ce que** la pastille séparée (11, 12) présente une ligne de séparation, qui est verticale ou presque verticale aux parties immédiatement adjacentes de la ligne (5, 6).

5. Circuit selon l'une des revendications 1 à 4, **caractérisé en ce que** les parties de la pastille séparée (11, 12) présentent une distance d'au moins 0,7 mm l'une de l'autre.

6. Circuit selon l'une des revendications précédentes, **caractérisé en ce que** l'élément de protection (4) est réalisé sous la forme d'une diode ou d'un Varistor ou d'un Thyristor.

7. Circuit selon l'une des revendications précédentes, **caractérisé en ce que** l'élément de protection (4) est relié en parallèle au composant électrique à protéger (3).

8. Circuit selon l'une des revendications précédentes, **caractérisé en ce que** le raccord (16) de l'élément de protection (4) reliant les parties de la ligne électrique (5, 6) est réalisé sous la forme d'au moins deux pattes de raccord reliées électriquement l'une à l'autre montées de façon distincte.

9. Circuit selon l'une des revendications 1 à 8, **caractérisé en ce que** l'autre pastille (14) présente au moins deux parties électriquement séparées l'une de l'autre.

10. Circuit selon l'une des revendications précédentes, **caractérisé en ce que** l'élément de protection (4) est constitué d'au moins deux couches de matériaux possédant différents coefficients de dilatation thermique.

11. Circuit selon la revendication 1, **caractérisé en ce que** l'étain à braser est utilisé en tant que brasure.
